# EUROPEAN PATENT APPLICATION

(11) **EP 4 841 287 A2**
(43) Date of publication of application: **18.11.2026**
(21) Application number: 26166066.6
(22) Date of filing: 19.03.2026
(51) Int. Cl.: G01R 33/09, G01R 33/00

(54) **ISOTROPIC TUNNEL MAGNETORESISTIVE TRANSDUCER WITH INTERLEAVING**

(30) Priority: 22.04.2025 US 202519185791
(71) Applicant: Allegro MicroSystems, LLC, Manchester, NH 03103 (US)
(72) Inventor: RIOULT, Maxime, 91300 Massy (FR); LOMBARD, Lucien, 38640 Claix (FR); CAMPIGLIO, Paolo, 94110 Arcueil (FR)
(74) Representative: South, Nicholas Geoffrey

(57) **Abstract**

An isotropic tunnel magnetoresistive transducer is constructed of tunnel magnetoresistive dots. The tunnel magnetoresistive dots include a first predetermined number of unidirectional tunnel magnetoresistive dots and a second predetermined number of corner tunnel magnetoresistive dots. Each unidirectional tunnel magnetoresistive dot includes a tunnel magnetoresistive pillar, a top contact, and a bottom contact parallel to the top contact. Each corner tunnel magnetoresistive dot includes a tunnel magnetoresistive pillar, a top contact, and a bottom contact perpendicular to the top contact. The tunnel magnetoresistive dots form branches of the isotropic tunnel magnetoresistive transducer. The second predetermined number of corner tunnel magnetoresistive dots is twice the first predetermined number of unidirectional tunnel magnetoresistive dots.

## Description

### BACKGROUND

As is known in the art, magnetic field sensors are often used to detect a ferromagnetic target so as to detect motion or position of the target. Such sensors are ubiquitous in many areas of technology including robotics, automotive, manufacturing, etc.

For example, a magnetic field sensor may be used to detect when a vehicle's wheel locks up, triggering the vehicle's control processor to engage the anti-lock braking system. In this example, the magnetic field sensor may detect rotation of the wheel.

Magnetic field sensors may also detect distance between the magnetic field sensor and an object. Sensors such as these may be used to detect the proximity of the object as it moves toward and away from the magnetic field sensor. Conventional magnetic field sensors typically include circular or square coils.

Conventional tunnel magnetoresistive based sensors use tunnel magnetoresistive elements arranged in a bridge configuration. Tunnel magnetoresistive based sensors may suffer from offset, mismatch, or drift due to the layout of the tunnel magnetoresistive elements forming the tunnel magnetoresistive based sensor.

Thus, conventional tunnel magnetoresistive based sensors suffer from diminished performance due to the layout of the tunnel magnetoresistive elements forming the tunnel magnetoresistive based sensor.

### SUMMARY

According to an aspect of the disclosure, a device includes an isotropic tunnel magnetoresistive transducer constructed of tunnel magnetoresistive dots, each tunnel magnetoresistive dot including a tunnel magnetoresistive pillar, a top contact, and a bottom contact; the tunnel magnetoresistive dots forming branches of the isotropic tunnel magnetoresistive transducer; each branch of the isotropic tunnel magnetoresistive transducer having a centroid; the centroid of each branch of the isotropic tunnel magnetoresistive transducer being a center of the isotropic tunnel magnetoresistive transducer.

According to another aspect of the disclosure, a device includes an isotropic tunnel magnetoresistive transducer constructed of tunnel magnetoresistive dots, each tunnel magnetoresistive dot including a tunnel magnetoresistive pillar, a top contact, and a bottom contact; the tunnel magnetoresistive dots forming branches of the isotropic tunnel magnetoresistive transducer; each branch of the isotropic tunnel magnetoresistive transducer having a center of mass; the center of mass of each branch of the isotropic tunnel magnetoresistive transducer being a center of the isotropic tunnel magnetoresistive transducer.

According to a further aspect of the disclosure, a device includes an isotropic tunnel magnetoresistive transducer constructed of tunnel magnetoresistive dots, the tunnel magnetoresistive dots including a first predetermined number of unidirectional tunnel magnetoresistive dots and a second predetermined number of corner tunnel magnetoresistive dots; each unidirectional tunnel magnetoresistive dot including a tunnel magnetoresistive pillar, a top contact, and a bottom contact parallel to the top contact; each corner tunnel magnetoresistive dot including a tunnel magnetoresistive pillar, a top contact, and a bottom contact perpendicular to the top contact; the tunnel magnetoresistive dots forming branches of the isotropic tunnel magnetoresistive transducer; the second predetermined number of corner tunnel magnetoresistive dots being twice the first predetermined number of unidirectional tunnel magnetoresistive dots.

In other embodiments, the device may include a second isotropic tunnel magnetoresistive transducer constructed of tunnel magnetoresistive dots, each tunnel magnetoresistive dot including a tunnel magnetoresistive pillar, a top contact, and a bottom contact; each isotropic tunnel magnetoresistive transducer having a common centroid. Each branch of the isotropic tunnel magnetoresistive transducer may have a Nₛ/Nₚ = 9, Nₛ being a number of tunnel magnetoresistive dots connected in series to form an array, Nₚ being a number of parallel arrays of serially connected tunnel magnetoresistive dots. A portion of the branches of the isotropic tunnel magnetoresistive transducer have a first direction of sensitivity and a remaining portion of the branches of the isotropic tunnel magnetoresistive transducer have a second direction of sensitivity. The isotropic tunnel magnetoresistive transducer may be constructed of vertical blocks of tunnel magnetoresistive dots and horizontal blocks of tunnel magnetoresistive dots; each branch of the isotropic tunnel magnetoresistive transducer having an equal number of vertical and horizontal blocks of tunnel magnetoresistive dots. The isotropic tunnel magnetoresistive transducer may be constructed of quadrants; the vertical blocks of tunnel magnetoresistive dots for a first branch of the isotropic tunnel magnetoresistive transducer being located in a quadrant and the horizontal blocks of tunnel magnetoresistive dots for the first branch of the isotropic tunnel magnetoresistive transducer being located in a different quadrant. The isotropic tunnel magnetoresistive transducer may have outer connections; the outer connections being serialized, parallelized, or both serialized and parallelized. The isotropic tunnel magnetoresistive transducer may be a voltage driven bridge, a current driven bridge, a resistance bridge, or a conductance bridge. The device may be an IC package.

In further embodiments, each branch may have a center of mass; the center of mass of each branch being a center of the isotropic tunnel magnetoresistive transducer. Each branch may have a centroid; the centroid of each branch being a center of the isotropic tunnel magnetoresistive transducer.

The isotropic tunnel magnetoresistive transducer may be constructed of a first quadrant of blocks of tunnel magnetoresistive dots, a second quadrant of blocks of tunnel magnetoresistive dots, a third quadrant of blocks of tunnel magnetoresistive dots, and a fourth quadrant of blocks of tunnel magnetoresistive dots; each quadrant of blocks of tunnel magnetoresistive dots having a sensitivity direction. The first and second quadrants of blocks of tunnel magnetoresistive dots may have a first direction of sensitivity and the third and fourth quadrants of blocks of tunnel magnetoresistive dots have a second direction of sensitivity.

The first quadrant of blocks of tunnel magnetoresistive dots may be constructed of a first subquadrant of vertical blocks of tunnel magnetoresistive dots and a second subquadrant of vertical blocks of tunnel magnetoresistive dots; the fourth quadrant of blocks of tunnel magnetoresistive dots being constructed of a third subquadrant of vertical blocks of tunnel magnetoresistive dots and a fourth subquadrant of vertical blocks of tunnel magnetoresistive dots; the second quadrant of blocks of tunnel magnetoresistive dots being constructed of a first subquadrant of horizontal blocks of tunnel magnetoresistive dots and a second subquadrant of horizontal blocks of tunnel magnetoresistive dots; the third quadrant of blocks of tunnel magnetoresistive dots being constructed of a third subquadrant of horizontal blocks of tunnel magnetoresistive dots and a fourth subquadrant of horizontal blocks of tunnel magnetoresistive dots. The isotropic tunnel magnetoresistive transducer may have a predetermined number of branches, each branch of the isotropic tunnel magnetoresistive transducer having an equal number of vertical blocks of tunnel magnetoresistive dots and horizontal blocks of tunnel magnetoresistive dots.

The first quadrant of blocks of tunnel magnetoresistive dots may be constructed of a plurality of first subquadrants of vertical blocks of tunnel magnetoresistive dots and a plurality of second subquadrants of vertical blocks of tunnel magnetoresistive dots, the plurality of first subquadrants of vertical blocks of tunnel magnetoresistive dots being interleaved with the plurality of second subquadrants of vertical blocks of tunnel magnetoresistive dots; the fourth quadrant of blocks of tunnel magnetoresistive dots being constructed of a plurality of third subquadrants of vertical blocks of tunnel magnetoresistive dots and a plurality of fourth subquadrants of vertical blocks of tunnel magnetoresistive dots, the plurality of third subquadrants of vertical blocks of tunnel magnetoresistive dots being interleaved with the plurality of fourth subquadrants of vertical blocks of tunnel magnetoresistive dots; the second quadrant of blocks of tunnel magnetoresistive dots being constructed of a plurality of first subquadrants of horizontal blocks of tunnel magnetoresistive dots and a plurality of second subquadrants of horizontal blocks of tunnel magnetoresistive dots, the plurality of first subquadrants of horizontal blocks of tunnel magnetoresistive dots being interleaved with the plurality of second subquadrants of horizontal blocks of tunnel magnetoresistive dots; the third quadrant of blocks of tunnel magnetoresistive dots being constructed of a plurality of third subquadrants of horizontal blocks of tunnel magnetoresistive dots and a plurality of fourth subquadrants of horizontal blocks of tunnel magnetoresistive dots, the plurality of third subquadrants of horizontal blocks of tunnel magnetoresistive dots being interleaved with the plurality of fourth subquadrants of horizontal blocks of tunnel magnetoresistive dots.

The isotropic tunnel magnetoresistive transducer may have a predetermined number of branches, each branch of the isotropic tunnel magnetoresistive transducer having an equal number of vertical blocks of tunnel magnetoresistive dots and horizontal blocks of tunnel magnetoresistive dots.

According to a further aspect of the disclosure, a method of constructing an IC package includes (a) forming subblocks of tunnel magnetoresistive dots, the tunnel magnetoresistive dots including a first predetermined number of unidirectional tunnel magnetoresistive dots and a second predetermined number of corner tunnel magnetoresistive dots, each unidirectional tunnel magnetoresistive dot including a tunnel magnetoresistive pillar, a top contact, and a bottom contact parallel to the top contact, each corner tunnel magnetoresistive dot including a tunnel magnetoresistive pillar, a top contact, and a bottom contact perpendicular to the top contact; (b) forming an isotropic tunnel magnetoresistive transducer of tunnel magnetoresistive dots by (b1) forming vertical blocks of tunnel magnetoresistive dots, each vertical block of tunnel magnetoresistive dots being constructed of a third predetermined number of subblocks of tunnel magnetoresistive dots, and (b2) forming horizontal blocks of tunnel magnetoresistive dots, each horizontal block of tunnel magnetoresistive dots being constructed of a fourth predetermined number of subblocks of tunnel magnetoresistive dots; and (c) forming, in the isotropic tunnel magnetoresistive transducer, branches of an isotropic tunnel magnetoresistive transducer, each branch of the isotropic tunnel magnetoresistive transducer having an equal number of vertical blocks of tunnel magnetoresistive dots and horizontal blocks of tunnel magnetoresistive dots; the second predetermined number of corner tunnel magnetoresistive dots in the isotropic tunnel magnetoresistive transducer being twice said first predetermined number of unidirectional tunnel magnetoresistive dots in the isotropic tunnel magnetoresistive transducer.

### BRIEF DESCRIPTION OF THE DRAWINGS

The drawings are only for purposes of illustrating various embodiments and are not to be construed as limiting, wherein:
FIG. 1 is a schematic representation of an example sensor having a tunnel magnetoresistive bridge with resistance equalization;
FIG. 2 illustrates various tunnel magnetoresistive dot configurations;
FIGS. 3-6 illustrate periodic cell configurations having staircase connected tunnel magnetoresistive dots;
FIG. 7 illustrates a table showing the make-up of tunnel magnetoresistive dot configurations for the periodic cell configurations of FIGS. 3-6 and the geometric variants thereof;
FIG. 8 illustrates an example of a staircase layout block;
FIG. 9 illustrates a sensor constructed of staircase connected layout blocks;
FIG. 10 illustrates interleaved bridges constructed of staircase connected layout blocks;
FIGS. 11 and 12 illustrate examples of a magnetometer-type bridge without interleaving;
FIGS. 13-16 illustrate periodic cell configurations having serpentine connected tunnel magnetoresistive dots;
FIG. 17 illustrates an example of a subblock constructed of periodic cell configurations of FIGS. 13-16;
FIG. 18 illustrates another example of a subblock constructed of periodic cell configurations of FIGS. 13-16;
FIG. 19 illustrates a vertical block of constructed of the periodic block or cell configurations of FIGS. 13-16;
FIG. 20 illustrates a horizontal block of constructed, after a counterclockwise rotation of 90°, of the periodic block or cell configurations of FIGS. 13-16;
FIG. 21 illustrates electrical connecting of the subblock of FIG. 17;
FIG. 22 illustrates orientation and electrical connecting of the vertical block of FIG. 19;
FIG. 23 illustrates orientation and electrical connecting of subblocks of FIG. 21 to construct a half horizontal block;
FIG. 24 is a table showing the make-up of tunnel magnetoresistive dot configurations of the vertical block of FIG. 22 and the horizontal block of FIG. 23;
FIG. 25 illustrates an example of half-block interleaving;
FIG. 26 illustrates an example of a magnetometer-type bridge using the half-block interleaving of FIG. 25; and
FIG. 27 illustrates an example of full block interleaving.

### DETAILED DESCRIPTION OF THE DRAWINGS

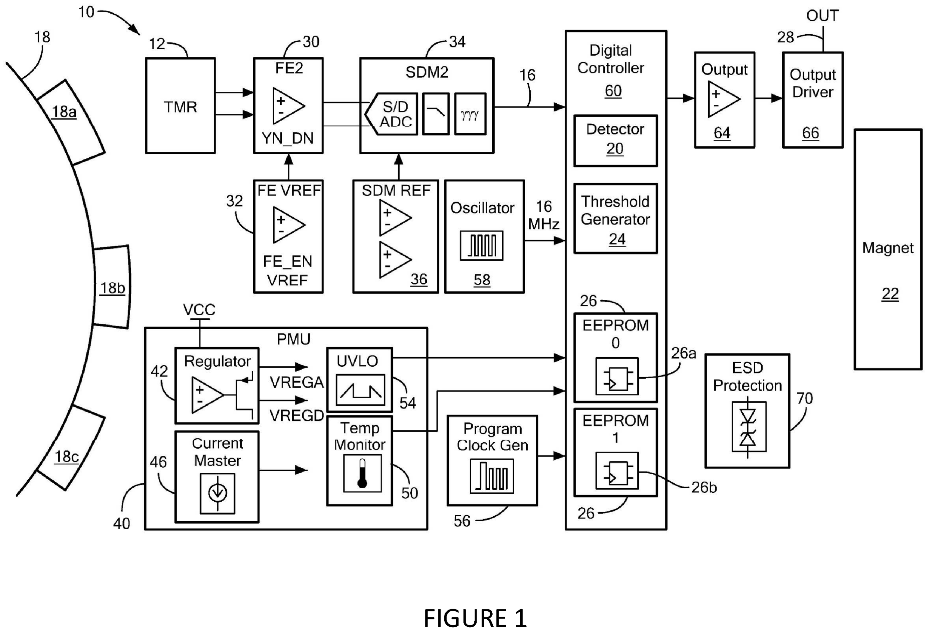

FIG. 1 shows an example magnetic field sensor 10 having at least one magnetic field sensing element 12 that includes one or more tunnel magnetoresistive elements configured to improve sensor performance as compared with conventional sensors. The sensor 10 is configured to generate a magnetic field signal 16 indicative of a magnetic field associated with a target 18 and a detector 20 responsive to the magnetic field signal and to a threshold level from a threshold generator 24 to generate a sensor output signal 28 containing transitions associated with features of the target in response to the magnetic field signal crossing the threshold level.

The target 18 can have a variety of forms, including, but not limited to a gear having gear teeth 18a-18c or a ring magnet having one or more pole pair. Also, linear arrangements of ferromagnetic objects that move linearly are possible. In the example embedment of FIG. 1, magnetic field sensor 10 may take the form of a rotation detector to detect passing gear teeth, for example, gear teeth 18a-18c of a ferromagnetic gear or, more generally target object 18. A permanent magnet 22 can be placed at a variety of positions proximate to the gear 18, resulting in fluctuations of a magnetic field proximate to the gear as the gear rotates in a so-called "back-bias" arrangement.

Features of the target 18 are spaced from the sensing elements 12 by an airgap. Although intended to be fixed once the sensor 10 is in place in a particular application, the airgap can vary for a variety of reasons. A difference between angles of the transitions of the sensor output signal 28 and locations of the associated features 18a-18c of the target 28 is referred to as a "hard offset."

Sensing elements 12 can take a variety of forms, such as tunnel magnetoresistive elements, as may be arranged in one or more bridge or other configurations to generate one or more single-ended or differential signals indicative of the sensed magnetic field. A front-end amplifier 30 can be used to process the magnetic field sensing element output signal to generate a further signal for coupling to an analog-to-digital converter 34 as may include one or more filters, such as a low pass filter and/or notch filter, and as may take the form of a sigma delta modulator to generate a digital magnetic field signal 16. Features of the magnetic field signal processing can include a front-end reference 32 and a sigma delta reference 36.

Sensor 10 includes a power management unit 40 as may contain various circuitry to perform power management functions. For example, a regulator 42 can output a regulated voltage for powering analog circuitry of the sensor (VREGA) and/or a regulated voltage for powering digital circuitry of the sensor (VREGD). A bias current source 46, a temperature monitor 50 and an undervoltage lockout 54 can monitor current, temperature, and voltage levels and provide associated status signals to a digital controller 60. A clock generation element 56 and an oscillator 58 are coupled to the digital controller 60.

Digital controller 60 processes the magnetic field signal 16 to determine the speed, position, and/or direction of movement, such as rotation of target 18 and outputs one or more digital signals to an output protocol module 64. More particularly, controller 60 determines the speed, position, and/or direction of target 18 based on the magnetic field signal 16 and can combine this information with fault information in some embodiments to generate the sensor output signal 28 in various formats. The output of module 64 is fed to an output driver 66 that provides the sensor output signal 28 in various formats, such as a so-called two-wire format in which the output signal is provided in the form of current pulses on the power connection to the sensor or a three-wire format in which the output signal is provided at a separate dedicated output connection.

Formats of the output signal 28 can include a variety of formats, for example a pulse-width modulated signal format, a Single Edge Nibble Transmission format, a Serial Peripheral Interface format, a Local Interconnect Network format, a Controller Area Network format, an Inter-Integrated Circuit format, or other similar signal formats. Sensor 10 can further include electrostatic discharge protection 70.

The digital controller 60 includes detector 20, threshold generator 24, and memory 26 such as EEPROMs 26a, 26b. Memory 26 can be used to store values for various sensor functionality including storing function coefficients for use by the threshold generator 24 in generating the adaptive threshold levels for use by detector 20.

Detector 20 is coupled to receive the threshold level thus generated and the magnetic field signal 16 and compare the received levels to generate a binary, two-state, detector output signal that has transitions when the signal 16 crosses the threshold level. Movement speed of the target 18 can be detected in accordance with the frequency of the binary signal.

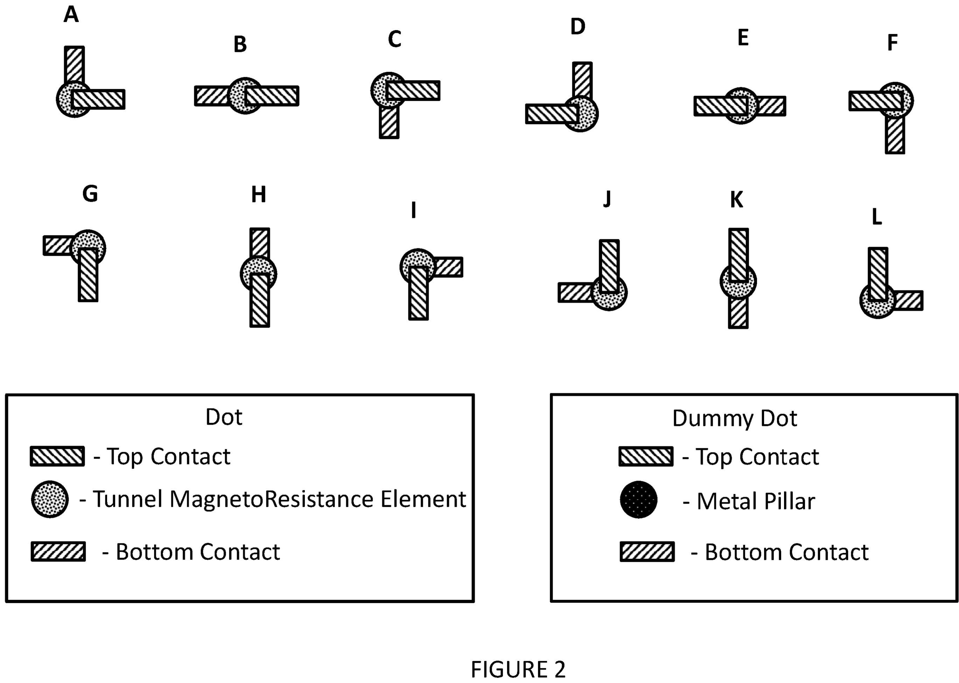

FIG. 2 illustrates various tunnel magnetoresistive dot configurations. As illustrated in FIG. 2, a tunnel magnetoresistive dot includes a top contact, a tunnel magnetoresistive element, and a bottom contact, wherein the contacts provide electrical connections between dots, and a dummy dot includes a top contact, a metal pillar, and a bottom contact, wherein the contacts provide electrical connections between dots. The top contact, tunnel magnetoresistive element, and a bottom contact of the tunnel magnetoresistive dot may be configured as a unidirectional tunnel magnetoresistive dot (B, E, H & K) or a corner tunnel magnetoresistive dot (A, C, D, F, G, I, J & L) thereby creating twelve variants of tunnel magnetoresistive dots, as illustrated.

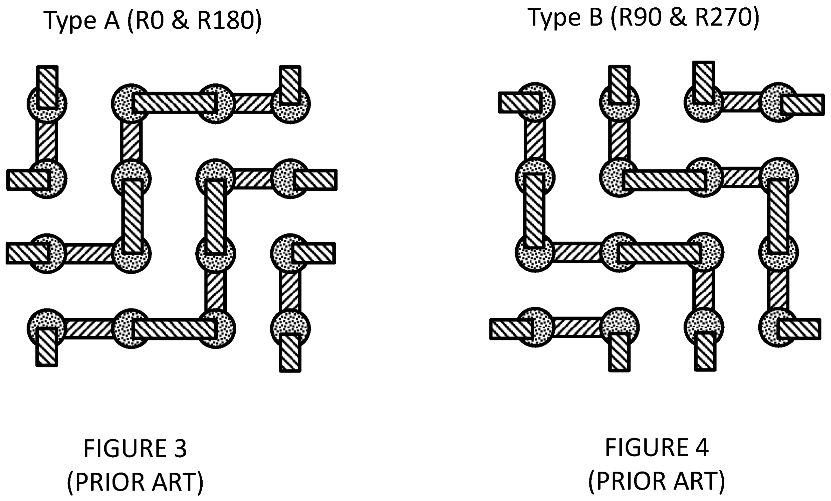

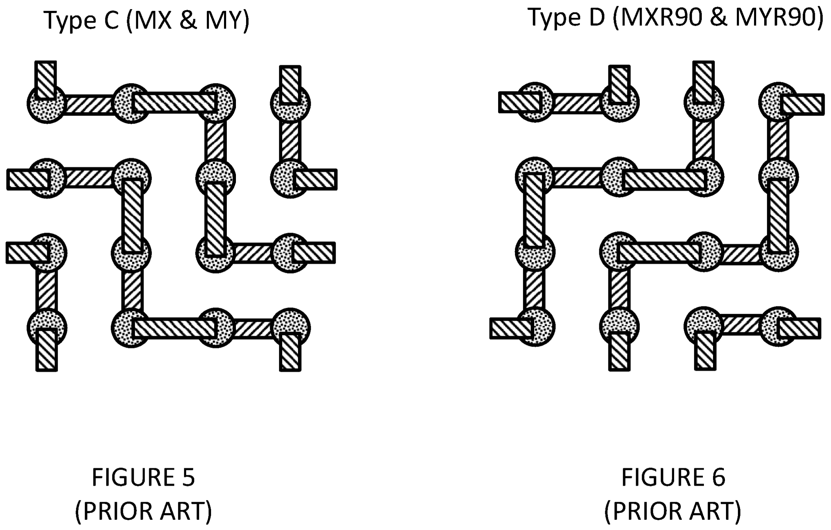

FIGS. 3 - 6 illustrate periodic cell configurations having staircase connected tunnel magnetoresistive dots. When connecting tunnel magnetoresistive dots in staircase configuration, a periodic block or cell, having an array of 4x4 tunnel magnetoresistive dots, is created. As illustrated In FIGS. 3 - 6, the staircase connection configuration creates four variants (Type A, Type B, Type C & Type D) of the periodic blocks with eight geometric variants (RO, R180, R90, R270, MX, MY, MXR90 & MYR90). The geometric variant of a periodic block is the periodic block rotated clockwise or counter-clockwise 180°.

It is noted that periodic blocks (Type A & Type D) have the same population of tunnel magnetoresistive dot variants, meaning that a tunnel magnetoresistive branch should not have both Type A & Type D periodic blocks. It is further noted that periodic blocks (Type B & Type C) have the same population of tunnel magnetoresistive dot variants, meaning that a tunnel magnetoresistive branch should not have both Type B & Type C periodic blocks.

In other words, a tunnel magnetoresistive branch should have one of the following configurations: (1) Type A & Type B; (2) Type A & Type C; (3) Type D & Type B; or (4) Type D & Type C.

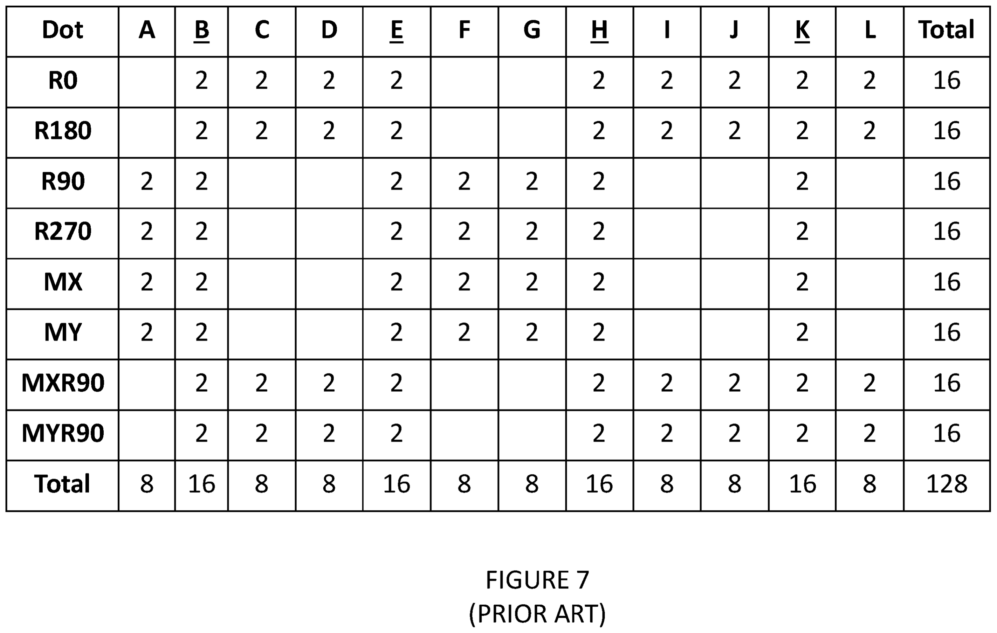

FIG. 7 illustrates a table showing the make-up of tunnel magnetoresistive dot configurations for the periodic block or cell configurations of FIGS. 3 - 6 and the geometric variants thereof. As shown in the table, for example, periodic block R0 has two B unidirectional tunnel magnetoresistive dots, two C corner tunnel magnetoresistive dots, two D corner tunnel magnetoresistive dots, two E unidirectional tunnel magnetoresistive dots, two H unidirectional tunnel magnetoresistive dots, two I corner tunnel magnetoresistive dots, two J corner tunnel magnetoresistive dots, two K unidirectional tunnel magnetoresistive dots, and two L unidirectional tunnel magnetoresistive dots, for a total of sixteen tunnel magnetoresistive dots.

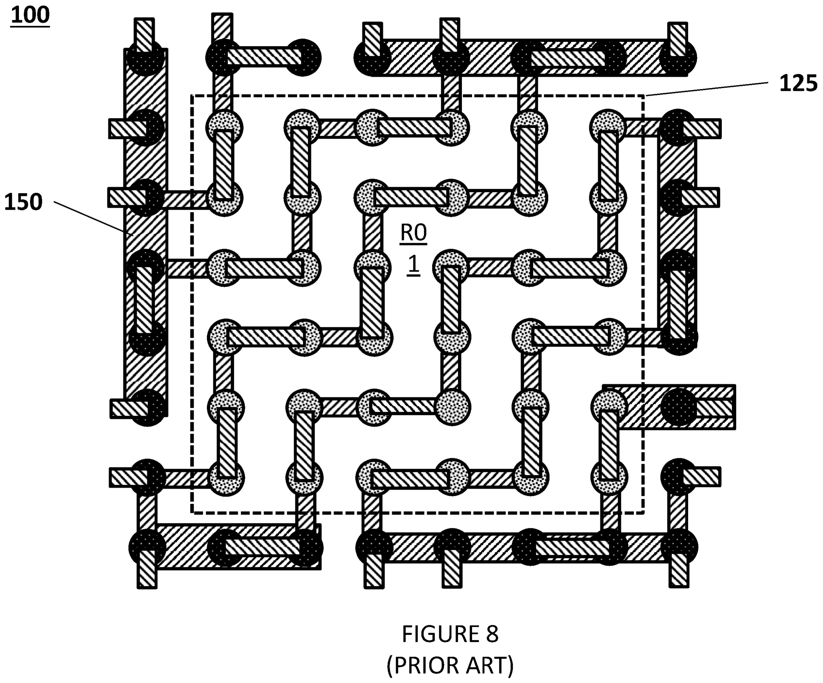

FIG. 8 illustrates an example of a staircase layout block. As illustrated in FIG. 8, a staircase layout block 100 includes an array of 6X6 tunnel magnetoresistive dots 125, configured as a R0 type block, and an optional line/column 150 of dummy dots on the edge of the array of 6X6 tunnel magnetoresistive dots 125.

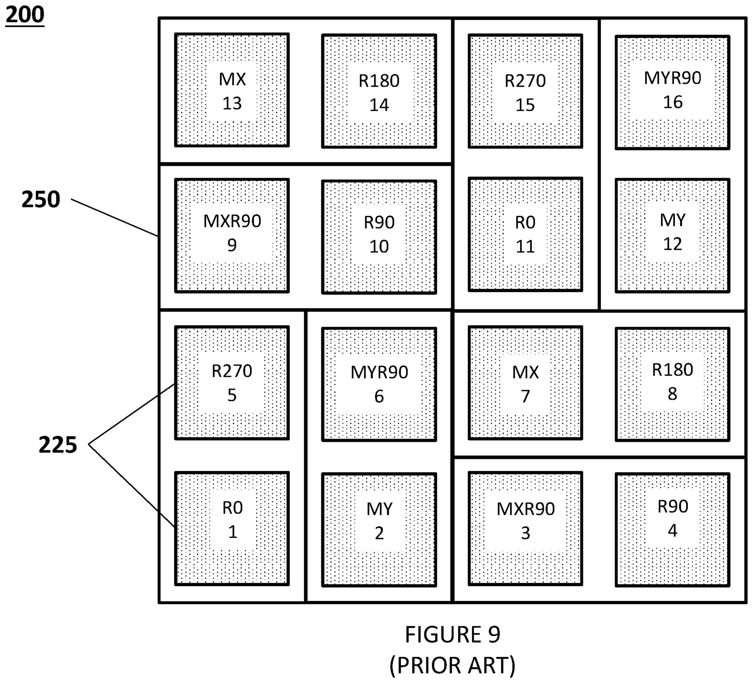

FIG. 9 illustrates a sensor constructed of staircase layout blocks. As illustrated in FIG. 9, a sensor 200 includes sixteen layout blocks 225, wherein two adjacent blocks (9 & 10) form a bridge branch 250. For example, as illustrated, a bridge branch may include a MXR90 type block and a R90 type block.

It is noted, with respect to the embodiment illustrated in FIG. 9, that the sensor is constructed of two independent bridges; however, the sensor can be constructed of a single bridge. It is further noted, with respect to the embodiment illustrated in FIG. 9, that the sensor is constructed of two adjacent blocks on a die; however, the blocks need not be located in adjacency on the die, but the blocks may be located at non-adjacent locations on the die.

It is noted that a bridge branch 250 is constructed of two staircase type layout blocks, which may be connected in parallel or in series.

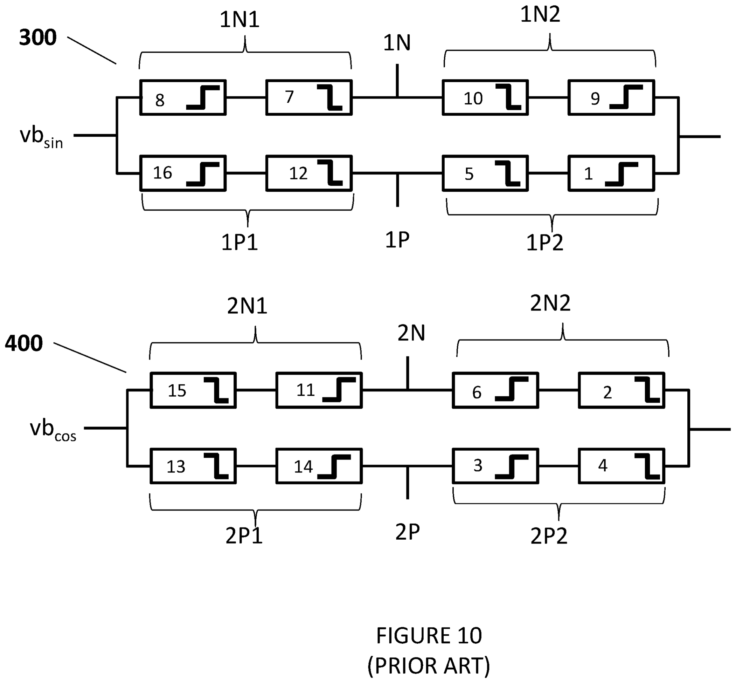

FIG. 10 illustrates interleaved bridges constructed of staircase type layout blocks. As illustrated in FIG. 10, a first interleaved bridge 300 includes a first branch 1N1 including layout blocks 8 & 7 of FIG. 9, a second branch 1N2 including layout blocks 10 & 9 of FIG. 9, a third branch 1P1 including layout blocks 16 & 12 of FIG. 9, and a fourth branch 1P2 including layout blocks 5 & 1 of FIG. 9. A second interleaved bridge 400 includes a first branch 2N1 including layout blocks 15 & 11 of FIG. 9, a second branch 2N2 including layout blocks 6 & 2 of FIG. 9, a third branch 2P1 including layout blocks 13 & 14 of FIG. 9, and a fourth branch 2P2 including layout blocks 3 & 4 of FIG. 9.

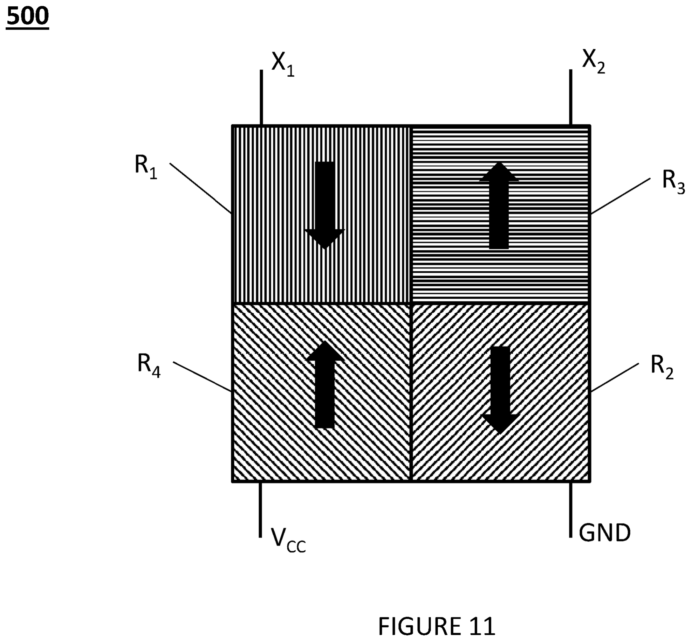

FIG. 11 illustrates an example of a magnetometer-type bridge without interleaving. As illustrated in Figure 11, a magnetometer-type bridge die 500 includes a first branch R₁, a second branch R₄, a third branch R₃, and a fourth branch R₂. First branch R₁ and fourth branch R₂ have the same sensitivity direction as represented by the arrows. Second branch R₄ and third branch R₃ have the same sensitivity direction as represented by the arrows.

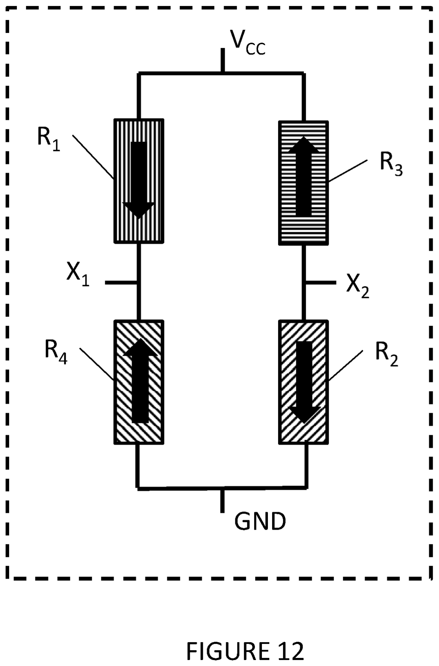

FIG. 12 illustrates the electrical layout of the magnetometer-type bridge of FIG. 11. As illustrated, first branch R₁ and third branch R₃ are connected to voltage source Vcc. Second branch R₄ and fourth branch R₂ are connected to ground GND.

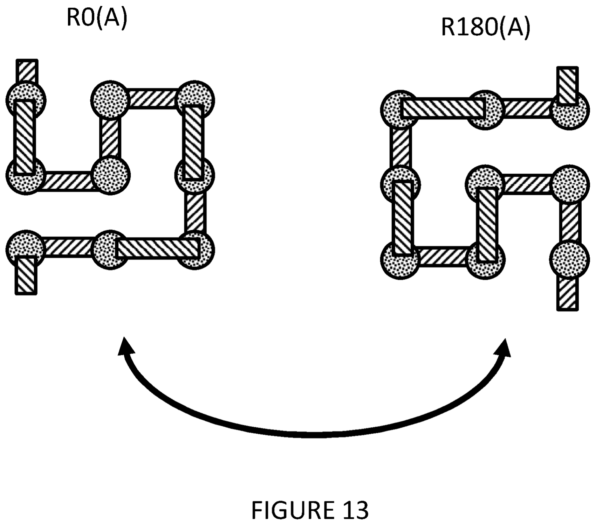

FIGS. 13 - 16 illustrate periodic cell configurations having serpentine connected tunnel magnetoresistive dots. When connecting tunnel magnetoresistive dots in a serpentine configuration, a periodic block or cell, having an array of 3x3 tunnel magnetoresistive dots, is created. As illustrated In FIGS. 13 - 16, the serpentine connection configuration creates two variants (A and B = reversing top and bottom contact of A) of the periodic blocks with four geometric variants (R0, R180, MX, MY), for a total of eight variants. The geometric variant of a periodic block is the periodic block rotated clockwise or counter-clockwise 180°.

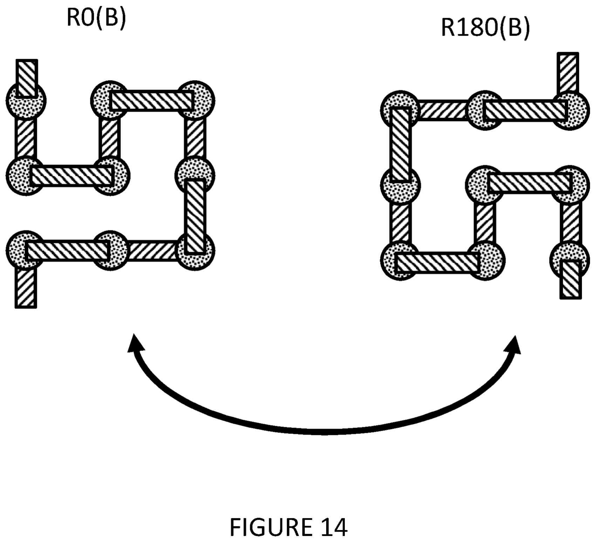

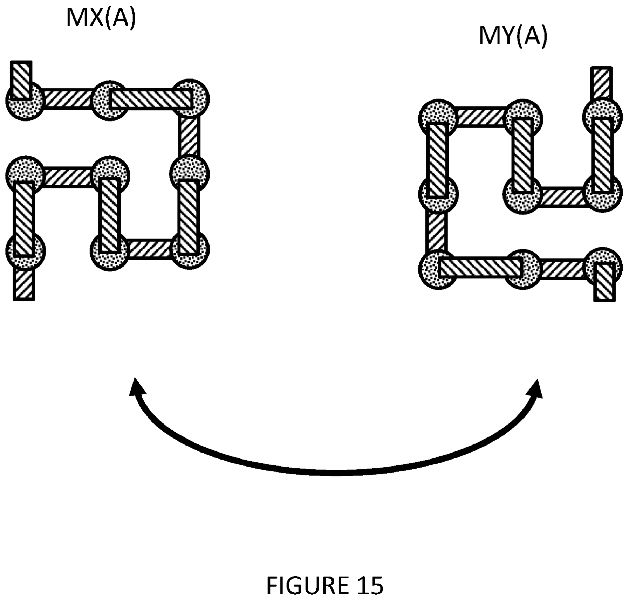

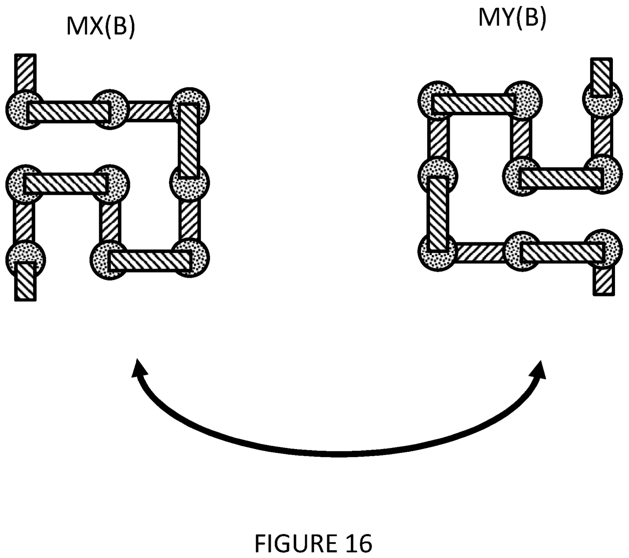

As illustrated in FIG. 13, periodic block R180(A) is periodic block RO(A) rotated clockwise or counter-clockwise 180°, as demonstrated by the double-ended arrow. As illustrated in FIG. 14, periodic block R180(B) is periodic block RO(B) rotated clockwise or counter-clockwise 180°, as demonstrated by the double-ended arrow. As illustrated in FIG. 15, periodic block MY(A) is periodic block MX(A) rotated clockwise or counter-clockwise 180°, as demonstrated by the double-ended arrow. As illustrated in FIG. 16, periodic block MY(B) is periodic block MX(B) rotated clockwise or counter-clockwise 180°, as demonstrated by the double-ended arrow.

It is noted that from input and output connections perspective, RO(A) and MX(B) are interchangeable; MX(A) and RO(B) are interchangeable; R180(A) and MY(B) are interchangeable; and MY(A) and R180(B) are interchangeable.

It is further noted that RO(A) or MX(B) can be connected to either RO(B) or MX(A), and that R180(A) or MY(B) can be connected to either R180(B) or MY(A).

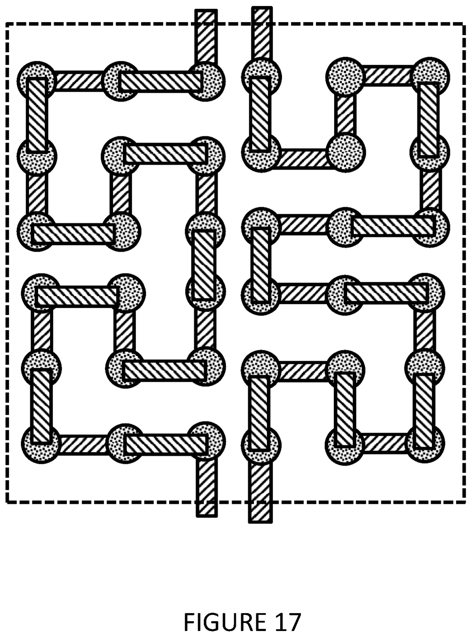

FIG. 17 illustrates an example of a subblock constructed of the periodic block or cell configurations of FIGS. 13 - 16. As illustrated in FIG. 17, in a first column, periodic block R180(B) of FIG. 14 is connected in series with periodic block MY(B) of FIG. 16. In a second column, periodic block RO(A) of FIG. 13 is connected in series with periodic block MX(A) of FIG. 15.

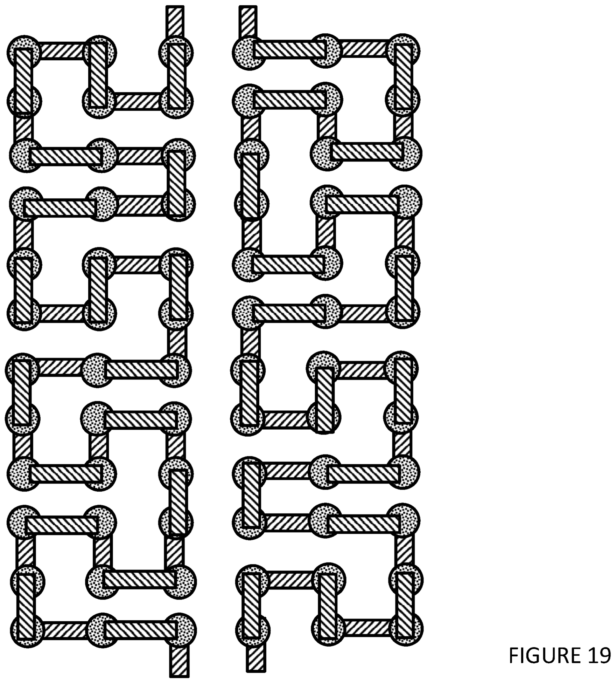

FIG. 19 illustrates a vertical block of constructed of the periodic block or cell configurations of FIGS. 13 - 16. As illustrated in FIG. 19, a vertical block is constructed of four lines of periodic blocks, a first column of serially connected periodic blocks, and a second column of serially connected periodic blocks.

The first column is constructed of periodic block MY(A) of FIG. 15 connected in series with periodic block R180(A) of FIG. 13, which is connected in series with periodic block R180(B) of FIG. 14, which is connected in series with periodic block MY(B) of FIG. 16.

The second column is constructed of periodic block MX(B) of FIG. 16 connected in series with periodic block RO(B) of FIG. 14, which is connected in series with periodic block RO(A) of FIG. 13, which is connected in series with periodic block MX(A) of FIG. 15.

It is noted that if the two columns are not connected, each column is four sub-blocks in series, each block having nine tunnel magnetoresistive dots, Ns/Np = 36, wherein Ns is the number of tunnel magnetoresistive dots connected in series and Np is the number of tunnel magnetoresistive dots connected in parallel. By connecting the two columns in FIG. 19 in parallel, Ns/Np = 18.

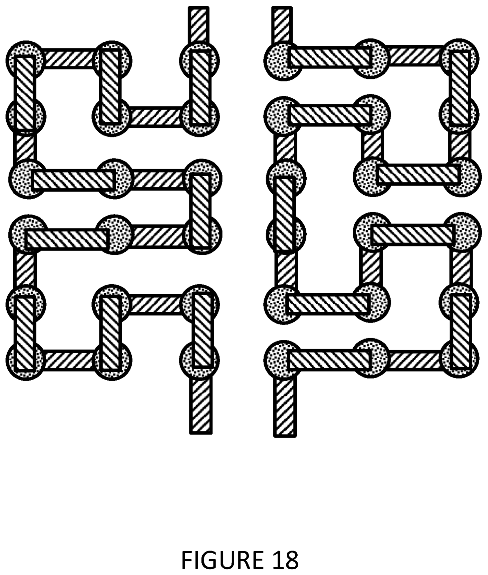

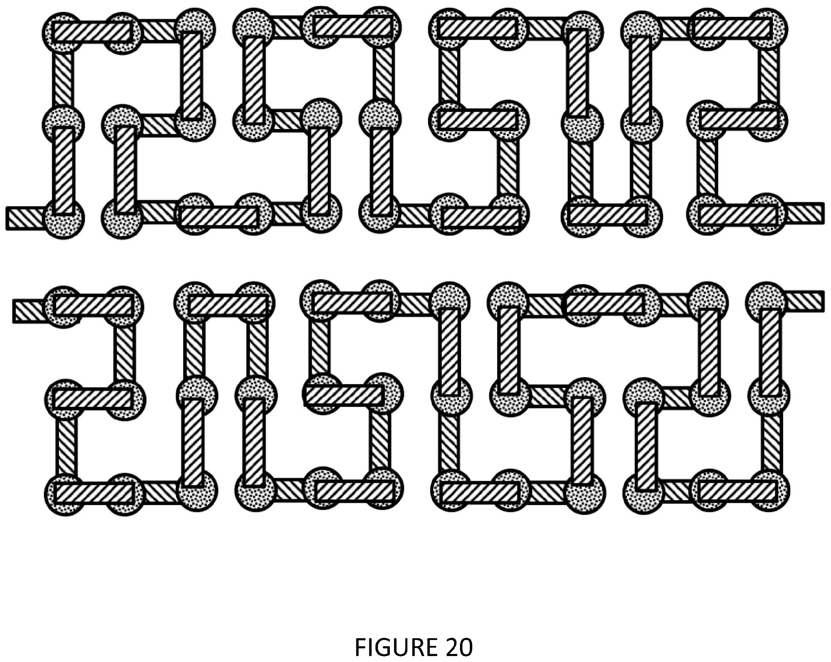

It is noted that a tunnel magnetoresistive branch should be constructed of at least one incompressible vertical block of FIG. 18 and one incompressible horizontal block of FIG. 20.

FIG. 18 illustrates another example of a subblock constructed of periodic cell configurations of FIGS. 13 - 16. As illustrated in FIG. 18, in a first column, periodic block MY(A) of FIG. 15 is connected in series with periodic block M180(A) of FIG. 13. In a second column, periodic block MX(B) of FIG. 16 is connected in series with periodic block RO(B) of FIG. 14.

FIG. 20 illustrates a horizontal block of constructed, after a counterclockwise rotation of 90°, of the periodic block or cell configurations of FIGS. 13 - 16. As illustrated in FIG. 20, a horizontal block is constructed of four column of periodic blocks, a first line of serially connected periodic blocks, and a second line of serially connected periodic blocks.

The first line is constructed of periodic block MX(B) of FIG. 16, after a counterclockwise rotation of 90°, connected in series with periodic block RO(B) of FIG. 14, after a counterclockwise rotation of 90°, which is connected in series with periodic block RO(A) of FIG. 13, after a counterclockwise rotation of 90°, which is connected in series with periodic block MX(A) of FIG. 15, after a counterclockwise rotation of 90°.

The second line is constructed of periodic block MY(A) of FIG. 15, after a counterclockwise rotation of 90°, connected in series with periodic block R180(A) of FIG. 13, after a counterclockwise rotation of 90°, which is connected in series with periodic block R180(B) of FIG. 14, after a counterclockwise rotation of 90°, which is connected in series with periodic block MY(B) of FIG. 16, after a counterclockwise rotation of 90°.

It is noted that if the two lines are not connected, each line is four sub-blocks in series, each block having nine tunnel magnetoresistive dots, Ns/Np = 36, wherein Ns is the number of tunnel magnetoresistive dots connected in series and Np is the number of tunnel magnetoresistive dots connected in parallel. By connecting the lines columns in FIG. 20 in parallel, Ns/Np = 18.

It is noted that a tunnel magnetoresistive branch should be constructed of at least one incompressible vertical block of FIG. 18 and one incompressible horizontal block of FIG. 20.

If the horizontal block of FIG. 20 and vertical block of FIG. 19 are connected in parallel, Ns/Np = 9.

If the horizontal block of FIG. 20 and vertical block of FIG. 19 are connected in parallel, the resulting configuration provides twelve repetitions of each dot variant for a total of one hundred forty-four dots.

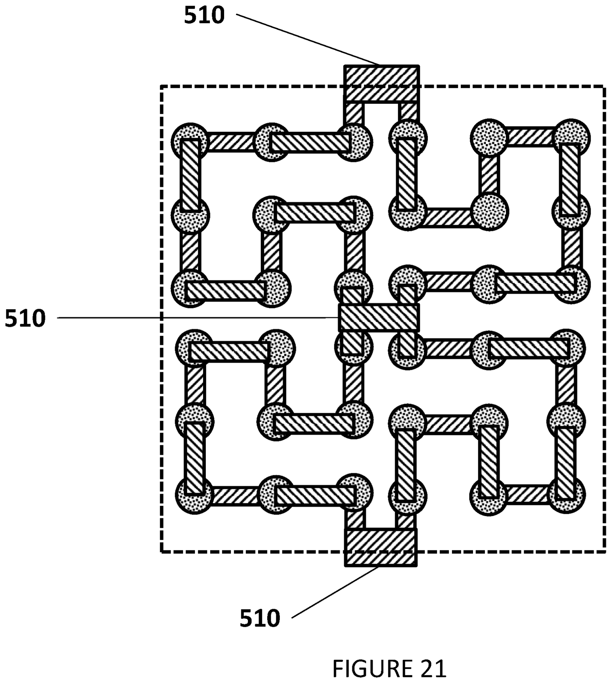

FIG. 21 illustrates electrical connecting of the subblock of FIG. 17. As illustrated, if horizontal connections 510 are utilized between the columns of 3x3 blocks, Ns/Np = 9.

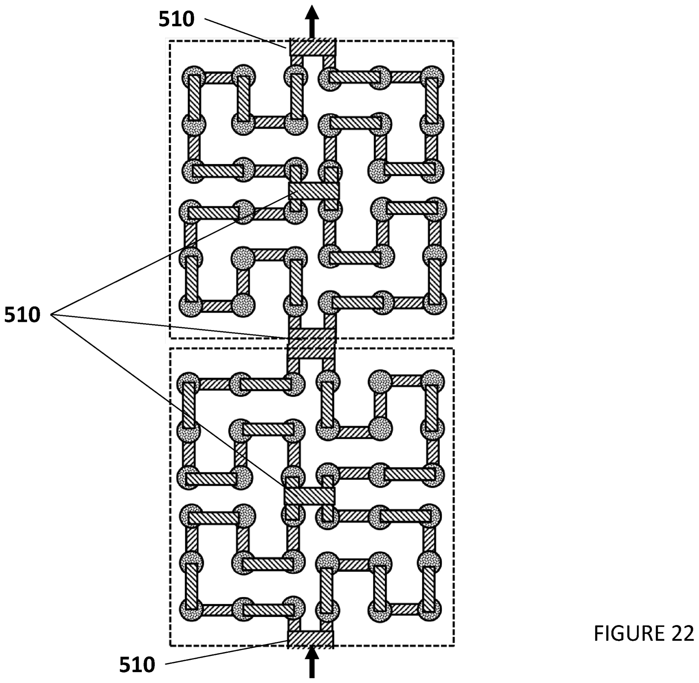

FIG. 22 illustrates orientation and electrical connecting of the vertical block of FIG. 19. As illustrated, if horizontal connections 510 are utilized between the columns of 3x3 blocks, Ns/Np = 18.

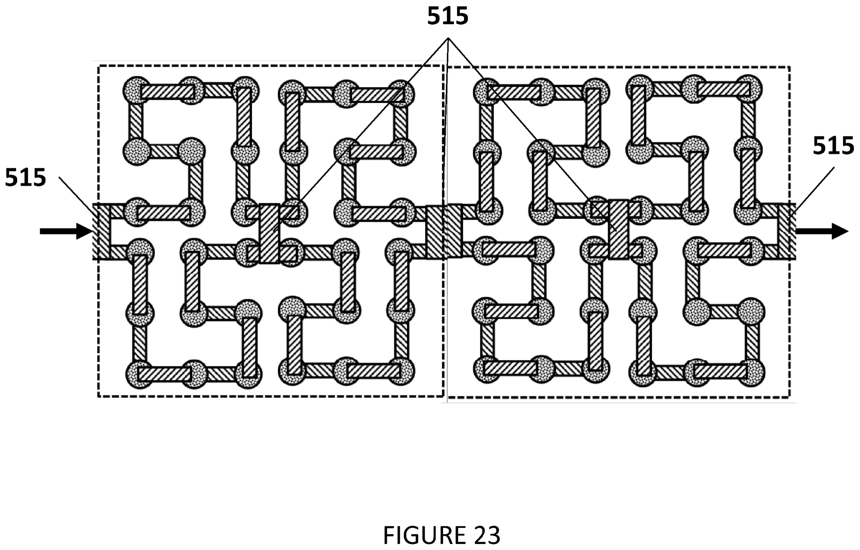

FIG. 23 illustrates orientation and electrical connecting of the horizontal block of FIG. 20. As illustrated, if vertical connections 515 are utilized between the lines of 3x3 blocks, Ns/Np = 18.

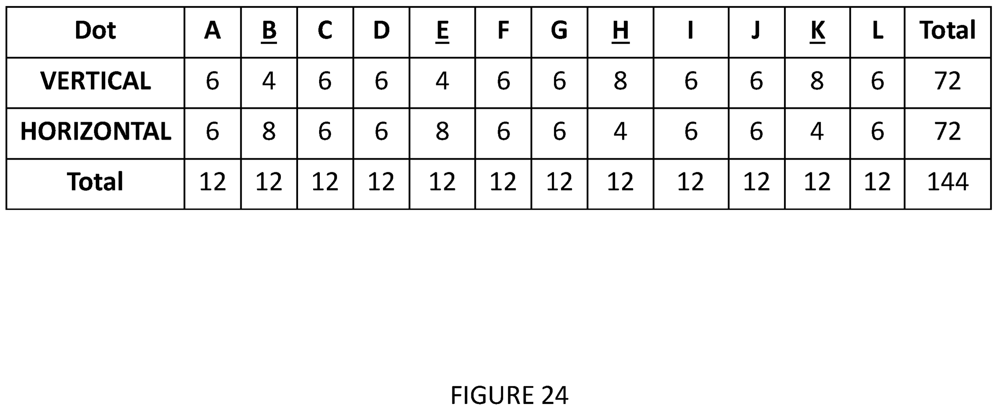

FIG. 24 is a table showing the make-up of tunnel magnetoresistive dot configurations of the vertical blocks of FIGS. 18 or 22 and the horizontal blocks of FIGS. 20 or 23. As shown in the table, for example, vertical block has six A corner tunnel magnetoresistive dots, four B unidirectional tunnel magnetoresistive dots, six C corner tunnel magnetoresistive dots, six D corner tunnel magnetoresistive dots, four E unidirectional tunnel magnetoresistive dots, six F corner tunnel magnetoresistive dots, six G corner tunnel magnetoresistive dots, eight H unidirectional tunnel magnetoresistive dots, six I corner tunnel magnetoresistive dots, six J corner tunnel magnetoresistive dots, eight K unidirectional tunnel magnetoresistive dots, and six L unidirectional tunnel magnetoresistive dots, for a total of seventy-two tunnel magnetoresistive dots.

The horizontal block has six A corner tunnel magnetoresistive dots, eight B unidirectional tunnel magnetoresistive dots, six C corner tunnel magnetoresistive dots, six D corner tunnel magnetoresistive dots, eight E unidirectional tunnel magnetoresistive dots, six F corner tunnel magnetoresistive dots, six G corner tunnel magnetoresistive dots, four H unidirectional tunnel magnetoresistive dots, six I corner tunnel magnetoresistive dots, six J corner tunnel magnetoresistive dots, four K unidirectional tunnel magnetoresistive dots, and six L unidirectional tunnel magnetoresistive dots, for a total of seventy-two tunnel magnetoresistive dots.

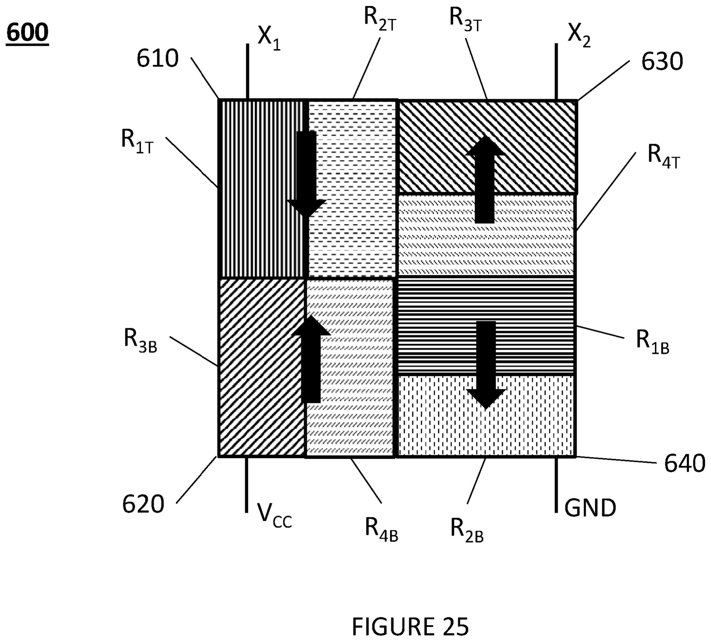

FIG. 25 illustrates an example of half-block interleaving. As illustrated, a magnetometer-type bridge die 600 includes a first block 610 having a first half block R₁₁ and a second half block R_{2T}, a second block 620 having a first half block R_{3B}, and a second half block R_{4B}, a third block 630 having a first half block R_{3T} and a second half block R_{4T}, and a fourth block 640 having a first half block R_{1B}, and a second half block R_{2B}, First block 610 and fourth block 640 have the same sensitivity direction as represented by the arrows. Second block 620 and third block 630 have the same sensitivity direction as represented by the arrows.

As illustrated in FIG. 25, a branch can be constructed of two half blocks from different blocks (with same sensitivity), wherein one half block is a vertical half block, and the other is a horizontal half block. For example, a branch can be constructed of half block R_{1T} and half block R_{1B}.

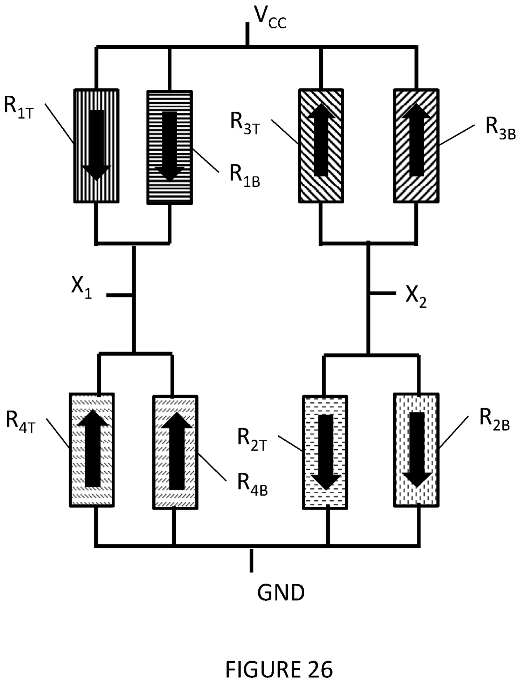

FIG. 26 illustrates an example of a magnetometer-type bridge using the half-block interleaving of FIG. 25. As illustrated, a first branch, including half block R_{1T} of FIG. 25 and half block R_{1B} of FIG. 25, and a third branch including half block R_{3T} of FIG. 25 and half block R_{3B} of FIG. 25, are connected to voltage source Vcc. A second branch, including half block R_{4T} of FIG. 25 and half block R_{4B} of FIG. 25, and a fourth branch, including half block R_{2T} of FIG. 25 and half block R_{2B} of FIG. 25, are connected to ground GND. By using half block interleaving, the electrical elements of the magnetometer-type bridge are spread over the die, thereby reducing the effects of offset, mismatch, or drift.

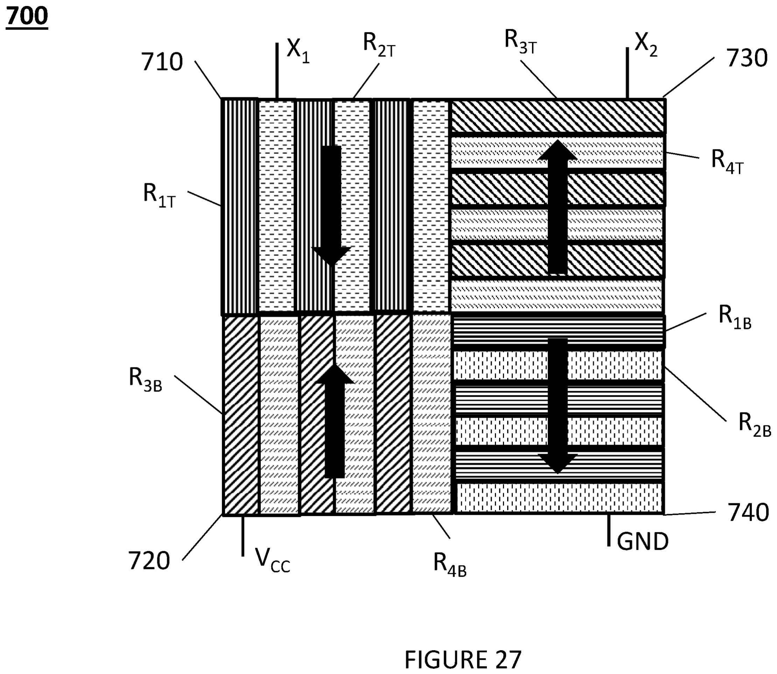

FIG. 27 illustrates an example of full block interleaving. As illustrated, a magnetometer-type bridge die 700 includes a first block 710 having multiple first slice blocks R_{1T} and multiple second slice blocks R_{2T}, a second block 720 having multiple first slice blocks R_{3B}, and multiple second slice blocks R_{4B}, a third block 730 having multiple first slice blocks R_{3T} and multiple second slice blocks R_{4T}, and a fourth block 740 having multiple first slice block R_{1B}, and multiple second slice block R_{2B}, First block 710 and fourth block 740 have the same sensitivity direction as represented by the arrows. Second block 720 and third block 730 have the same sensitivity direction as represented by the arrows.

As illustrated in FIG. 27, a branch can be constructed of multiple slice blocks from different blocks, wherein a number of slice blocks are vertical slice blocks, and another number of slice blocks are horizontal slice blocks. For example, a branch can be constructed of multiple slice blocks R_{1T} and multiple slice blocks R_{1B}.

As noted above, an isotropic tunnel magnetoresistive transducer is constructed of tunnel magnetoresistive dots, each tunnel magnetoresistive dot including a tunnel magnetoresistive pillar, a top contact, and a bottom contact. The tunnel magnetoresistive dots form branches of the isotropic tunnel magnetoresistive transducer.

In one embodiment, each branch of the isotropic tunnel magnetoresistive transducer has a centroid, and the centroid of each branch of the isotropic tunnel magnetoresistive transducer is a center of the isotropic tunnel magnetoresistive transducer.

It is noted that each branch of an isotropic tunnel magnetoresistive transducer has a Nₛ/Nₚ = 9, wherein Nₛ is a number of tunnel magnetoresistive dots connected in series to form an array, and Nₚ is a number of parallel arrays of serially connected tunnel magnetoresistive dots.

It is noted that although the above embodiments included a tunnel magnetoresistive sensor implementation, the described and claimed tunnel magnetoresistive dot layout may be used for any application and any magnetic field source; for example, a rotating magnet; a magnet's position vs an air gap; a magnet's position vs a lateral position; a field generated by a printed circuit board trace, a field generated by a lead frame integrated on a die package; or a field generated by a current line integrated on a chip.

An isotropic tunnel magnetoresistive transducer is constructed of quadrants, wherein vertical blocks of tunnel magnetoresistive dots for a first branch of the isotropic tunnel magnetoresistive transducer are located in a quadrant and horizontal blocks of tunnel magnetoresistive dots for the first branch of the isotropic tunnel magnetoresistive transducer are located in a different quadrant.

It is noted that each branch of an isotropic tunnel magnetoresistive transducer has a center of mass, wherein the center of mass of each branch of the isotropic tunnel magnetoresistive transducer is a center of the isotropic tunnel magnetoresistive transducer.

An isotropic tunnel magnetoresistive transducer is constructed of tunnel magnetoresistive dots, the tunnel magnetoresistive dots including a first predetermined number of unidirectional tunnel magnetoresistive dots and a second predetermined number of corner tunnel magnetoresistive dots. Each unidirectional tunnel magnetoresistive dot includes a tunnel magnetoresistive pillar, a top contact, and a bottom contact parallel to the top contact, and each corner tunnel magnetoresistive dot includes a tunnel magnetoresistive pillar, a top contact, and a bottom contact perpendicular to the top contact.

The tunnel magnetoresistive dots form branches of the isotropic tunnel magnetoresistive transducer, wherein the second predetermined number of corner tunnel magnetoresistive dots is twice the first predetermined number of unidirectional tunnel magnetoresistive dots. The isotropic tunnel magnetoresistive transducer is constructed of vertical blocks of tunnel magnetoresistive dots and horizontal blocks of tunnel magnetoresistive dots, wherein each branch of the isotropic tunnel magnetoresistive transducer has an equal number of vertical and horizontal blocks of tunnel magnetoresistive dots.

The isotropic tunnel magnetoresistive transducer is constructed of quadrants of blocks of tunnel magnetoresistive dots, wherein a first quadrant of blocks of tunnel magnetoresistive dots is constructed of a plurality of first subquadrants of vertical blocks of tunnel magnetoresistive dots and a plurality of second subquadrants of vertical blocks of tunnel magnetoresistive dots, the plurality of first subquadrants of vertical blocks of tunnel magnetoresistive dots being interleaved with the plurality of second subquadrants of vertical blocks of tunnel magnetoresistive dots.

A fourth quadrant of blocks of tunnel magnetoresistive dots is constructed of a plurality of third subquadrants of vertical blocks of tunnel magnetoresistive dots and a plurality of fourth subquadrants of vertical blocks of tunnel magnetoresistive dots, the plurality of third subquadrants of vertical blocks of tunnel magnetoresistive dots being interleaved with the plurality of fourth subquadrants of vertical blocks of tunnel magnetoresistive dots.

A second quadrant of blocks of tunnel magnetoresistive dots is constructed of a plurality of first subquadrants of horizontal blocks of tunnel magnetoresistive dots and a plurality of second subquadrants of horizontal blocks of tunnel magnetoresistive dots, the plurality of first subquadrants of horizontal blocks of tunnel magnetoresistive dots being interleaved with the plurality of second subquadrants of horizontal blocks of tunnel magnetoresistive dots.

A third quadrant of blocks of tunnel magnetoresistive dots is constructed of a plurality of third subquadrants of horizontal blocks of tunnel magnetoresistive dots and a plurality of fourth subquadrants of horizontal blocks of tunnel magnetoresistive dots, the plurality of third subquadrants of horizontal blocks of tunnel magnetoresistive dots being interleaved with the plurality of fourth subquadrants of horizontal blocks of tunnel magnetoresistive dots.

A method of constructing an isotropic tunnel magnetoresistive transducer (a) forms subblocks of tunnel magnetoresistive dots, the tunnel magnetoresistive dots including a first predetermined number of unidirectional tunnel magnetoresistive dots and a second predetermined number of corner tunnel magnetoresistive dots, each unidirectional tunnel magnetoresistive dot including a tunnel magnetoresistive pillar, a top contact, and a bottom contact parallel to the top contact, each corner tunnel magnetoresistive dot including a tunnel magnetoresistive pillar, a top contact, and a bottom contact perpendicular to the top contact; (b) forms an isotropic tunnel magnetoresistive transducer of tunnel magnetoresistive dots by (b1) forming vertical blocks of tunnel magnetoresistive dots, each vertical block of tunnel magnetoresistive dots being constructed of a third predetermined number of subblocks of tunnel magnetoresistive dots, and (b2) forming horizontal blocks of tunnel magnetoresistive dots, each horizontal block of tunnel magnetoresistive dots being constructed of a fourth predetermined number of subblocks of tunnel magnetoresistive dots; and (c) forms, in the isotropic tunnel magnetoresistive transducer, branches of an isotropic tunnel magnetoresistive transducer, each branch of the isotropic tunnel magnetoresistive transducer having an equal number of vertical blocks of tunnel magnetoresistive dots and horizontal blocks of tunnel magnetoresistive dots; the second predetermined number of corner tunnel magnetoresistive dots in the isotropic tunnel magnetoresistive transducer being twice said first predetermined number of unidirectional tunnel magnetoresistive dots in the isotropic tunnel magnetoresistive transducer.

It will be appreciated that variations of the above-disclosed embodiments and other features and functions, or alternatives thereof, may be desirably combined into many other different systems or applications. Also, various presently unforeseen or unanticipated alternatives, modifications, variations or improvements therein may be subsequently made by those skilled in the art which are also intended to be encompassed by the description above and the following claims.

## Claims

1. A device comprising:
an isotropic tunnel magnetoresistive transducer constructed of tunnel magnetoresistive dots, each tunnel magnetoresistive dot including a tunnel magnetoresistive pillar, a top contact, and a bottom contact;
said tunnel magnetoresistive dots forming branches of said isotropic tunnel magnetoresistive transducer;
each branch of said isotropic tunnel magnetoresistive transducer having a centroid;
said centroid of each branch of said isotropic tunnel magnetoresistive transducer being a center of said isotropic tunnel magnetoresistive transducer.

2. A device comprising:
an isotropic tunnel magnetoresistive transducer constructed of tunnel magnetoresistive dots, each tunnel magnetoresistive dot including a tunnel magnetoresistive pillar, a top contact, and a bottom contact;
said tunnel magnetoresistive dots forming branches of said isotropic tunnel magnetoresistive transducer;
each branch of said isotropic tunnel magnetoresistive transducer having a center of mass;
said center of mass of each branch of said isotropic tunnel magnetoresistive transducer being a center of said isotropic tunnel magnetoresistive transducer.

3. The device as claimed in claim 1 or 2, further comprising a second isotropic tunnel magnetoresistive transducer constructed of tunnel magnetoresistive dots, each tunnel magnetoresistive dot including a tunnel magnetoresistive pillar, a top contact, and a bottom contact;
each isotropic tunnel magnetoresistive transducer having a common centroid.

4. A device comprising:
an isotropic tunnel magnetoresistive transducer constructed of tunnel magnetoresistive dots, said tunnel magnetoresistive dots including a first predetermined number of unidirectional tunnel magnetoresistive dots and a second predetermined number of corner tunnel magnetoresistive dots;
each unidirectional tunnel magnetoresistive dot including a tunnel magnetoresistive pillar, a top contact, and a bottom contact parallel to the top contact;
each corner tunnel magnetoresistive dot including a tunnel magnetoresistive pillar, a top contact, and a bottom contact perpendicular to the top contact;
said tunnel magnetoresistive dots forming branches of said isotropic tunnel magnetoresistive transducer;
said second predetermined number of corner tunnel magnetoresistive dots being twice said first predetermined number of unidirectional tunnel magnetoresistive dots.

5. The device as claimed in claim 1, 2 or 4, wherein each branch of said isotropic tunnel magnetoresistive transducer has a Nₛ/Nₚ = 9, Nₛ being a number of tunnel magnetoresistive dots connected in series to form an array, Nₚ being a number of parallel arrays of serially connected tunnel magnetoresistive dots.

6. The device as claimed in claim 1, 2 or 4, wherein said isotropic tunnel magnetoresistive transducer is constructed of vertical blocks of tunnel magnetoresistive dots and horizontal blocks of tunnel magnetoresistive dots;
each branch of said isotropic tunnel magnetoresistive transducer having an equal number of vertical and horizontal blocks of tunnel magnetoresistive dots.

7. The device as claimed in claim 6, wherein said isotropic tunnel magnetoresistive transducer is constructed of quadrants;
said vertical blocks of tunnel magnetoresistive dots for a first branch of said isotropic tunnel magnetoresistive transducer being located in a quadrant and said horizontal blocks of tunnel magnetoresistive dots for said first branch of said isotropic tunnel magnetoresistive transducer being located in a different quadrant.

8. The device as claimed in claim 1, 2 or 4, wherein said isotropic tunnel magnetoresistive transducer has outer connections;
said outer connections being serialized, parallelized, or both serialized and parallelized.

9. The device as claimed in claim 1, 2 or 4, wherein the device is an IC package.

10. The device as claimed in claim 4, wherein said isotropic tunnel magnetoresistive transducer is constructed of a first quadrant of blocks of tunnel magnetoresistive dots, a second quadrant of blocks of tunnel magnetoresistive dots, a third quadrant of blocks of tunnel magnetoresistive dots, and a fourth quadrant of blocks of tunnel magnetoresistive dots;
each quadrant of blocks of tunnel magnetoresistive dots having a sensitivity direction.

11. The device as claimed in claim 10, wherein said first and second quadrants of blocks of tunnel magnetoresistive dots have a first direction of sensitivity and said third and fourth quadrants of blocks of tunnel magnetoresistive dots have a second direction of sensitivity.

12. The device as claimed in claim 10, wherein said first quadrant of blocks of tunnel magnetoresistive dots is constructed of a first subquadrant of vertical blocks of tunnel magnetoresistive dots and a second subquadrant of vertical blocks of tunnel magnetoresistive dots;
said fourth quadrant of blocks of tunnel magnetoresistive dots being constructed of a third subquadrant of vertical blocks of tunnel magnetoresistive dots and a fourth subquadrant of vertical blocks of tunnel magnetoresistive dots;
said second quadrant of blocks of tunnel magnetoresistive dots being constructed of a first subquadrant of horizontal blocks of tunnel magnetoresistive dots and a second subquadrant of horizontal blocks of tunnel magnetoresistive dots;
said third quadrant of blocks of tunnel magnetoresistive dots being constructed of a third subquadrant of horizontal blocks of tunnel magnetoresistive dots and a fourth subquadrant of horizontal blocks of tunnel magnetoresistive dots.

13. The device as claimed in claim 12, wherein said isotropic tunnel magnetoresistive transducer has a predetermined number of branches, each branch of said isotropic tunnel magnetoresistive transducer having an equal number of vertical blocks of tunnel magnetoresistive dots and horizontal blocks of tunnel magnetoresistive dots.

14. A method of constructing an IC package, comprising:
(a) forming subblocks of tunnel magnetoresistive dots, the tunnel magnetoresistive dots including a first predetermined number of unidirectional tunnel magnetoresistive dots and a second predetermined number of corner tunnel magnetoresistive dots, each unidirectional tunnel magnetoresistive dot including a tunnel magnetoresistive pillar, a top contact, and a bottom contact parallel to the top contact, each corner tunnel magnetoresistive dot including a tunnel magnetoresistive pillar, a top contact, and a bottom contact perpendicular to the top contact;
(b) forming an isotropic tunnel magnetoresistive transducer of tunnel magnetoresistive dots by
(b1) forming vertical blocks of tunnel magnetoresistive dots, each vertical block of tunnel magnetoresistive dots being constructed of a third predetermined number of subblocks of tunnel magnetoresistive dots, and
(b2) forming horizontal blocks of tunnel magnetoresistive dots, each horizontal block of tunnel magnetoresistive dots being constructed of a fourth predetermined number of subblocks of tunnel magnetoresistive dots; and
(c) forming, in the isotropic tunnel magnetoresistive transducer, branches of an isotropic tunnel magnetoresistive transducer, each branch of the isotropic tunnel magnetoresistive transducer having an equal number of vertical blocks of tunnel magnetoresistive dots and horizontal blocks of tunnel magnetoresistive dots;
the second predetermined number of corner tunnel magnetoresistive dots in the isotropic tunnel magnetoresistive transducer being twice said first predetermined number of unidirectional tunnel magnetoresistive dots in the isotropic tunnel magnetoresistive transducer.

15. The method as claimed in claim 14, wherein each subblock of tunnel magnetoresistive dots has a Nₛ/Nₚ = 9, Nₛ being a number of tunnel magnetoresistive dots connected in series to form an array, Nₚ being a number of parallel arrays of serially connected tunnel magnetoresistive dots.

16. The method as claimed in claim 14, or the device of claim 1, 2 or 4, wherein a portion of the branches of the isotropic tunnel magnetoresistive transducer have a first direction of sensitivity and a remaining portion of the branches of the isotropic tunnel magnetoresistive transducer have a second direction of sensitivity.

17. The method as claimed in claim 14, wherein the isotropic tunnel magnetoresistive transducer is constructed of a first quadrant of blocks of tunnel magnetoresistive dots, a second quadrant of blocks of tunnel magnetoresistive dots, a third quadrant of blocks of tunnel magnetoresistive dots, and a fourth quadrant of blocks of tunnel magnetoresistive dots;
each quadrant of blocks of tunnel magnetoresistive dots having a sensitivity direction.

18. The method as claimed in claim 17, wherein the first and second quadrants of blocks of tunnel magnetoresistive dots have a first direction of sensitivity and the third and fourth quadrants of blocks of tunnel magnetoresistive dots have a second direction of sensitivity.

19. The method as claimed in claim 48, or the device of claim 10 or 13, wherein the first quadrant of blocks of tunnel magnetoresistive dots is constructed of a plurality of first subquadrants of vertical blocks of tunnel magnetoresistive dots and a plurality of second subquadrants of vertical blocks of tunnel magnetoresistive dots, the plurality of first subquadrants of vertical blocks of tunnel magnetoresistive dots being interleaved with the plurality of second subquadrants of vertical blocks of tunnel magnetoresistive dots;
the fourth quadrant of blocks of tunnel magnetoresistive dots being constructed of a plurality of third subquadrants of vertical blocks of tunnel magnetoresistive dots and a plurality of fourth subquadrants of vertical blocks of tunnel magnetoresistive dots, the plurality of third subquadrants of vertical blocks of tunnel magnetoresistive dots being interleaved with the plurality of fourth subquadrants of vertical blocks of tunnel magnetoresistive dots;
the second quadrant of blocks of tunnel magnetoresistive dots being constructed of a plurality of first subquadrants of horizontal blocks of tunnel magnetoresistive dots and a plurality of second subquadrants of horizontal blocks of tunnel magnetoresistive dots, the plurality of first subquadrants of horizontal blocks of tunnel magnetoresistive dots being interleaved with the plurality of second subquadrants of horizontal blocks of tunnel magnetoresistive dots;
the third quadrant of blocks of tunnel magnetoresistive dots being constructed of a plurality of third subquadrants of horizontal blocks of tunnel magnetoresistive dots and a plurality of fourth subquadrants of horizontal blocks of tunnel magnetoresistive dots, the plurality of third subquadrants of horizontal blocks of tunnel magnetoresistive dots being interleaved with the plurality of fourth subquadrants of horizontal blocks of tunnel magnetoresistive dots.

20. The method as claimed in claim 14, or the device of claim 4, wherein each branch of the isotropic tunnel magnetoresistive transducer has a center of mass, the center of mass of each branch of the isotropic tunnel magnetoresistive transducer being a center of the isotropic tunnel magnetoresistive transducer.

21. The method as claimed in claim 14, or the device of claim 4, wherein each branch of the isotropic tunnel magnetoresistive transducer has a centroid; the centroid of each branch of the isotropic tunnel magnetoresistive transducer being a center of the isotropic tunnel magnetoresistive transducer.

22. The method as claimed in claim 14, further comprising:
(d) forming outer connections around the isotropic tunnel magnetoresistive transducer, the outer connections being serialized, parallelized, or both serialized and parallelized.

23. The method as claimed in claim 14, or the device of claim 1, 2 or 4, wherein the isotropic tunnel magnetoresistive transducer is a voltage driven bridge.

24. The method as claimed in claim 14, or the device of claim 1, 2 or 4, wherein the isotropic tunnel magnetoresistive transducer is a current driven bridge.

25. The method as claimed in claim 14, or the device of claim 1, 2 or 4, wherein the isotropic tunnel magnetoresistive transducer is a resistance bridge.

26. The method as claimed in claim 14, or the device of claim 1, 2 or 4, wherein the isotropic tunnel magnetoresistive transducer is a conductance bridge.
